Europäisches Patentamt

(19) **European Patent Office**

**Office européen des brevets**

(11) Publication number: **0 124 975**
**A1**

## (12) EUROPEAN PATENT APPLICATION

(21) Application number: **84301726.0**

(22) Date of filing: **14.03.84**

(51) Int. Cl.³: **H 01 L 31/18**
**H 01 L 21/60, H 01 L 21/68**

(30) Priority: **14.03.83 US 474830**

(43) Date of publication of application:
**14.11.84 Bulletin 84/46**

(84) Designated Contracting States:
**DE FR GB IT**

(71) Applicant: **Exxon Research and Engineering Company**
**P.O.Box 390 180 Park Avenue**
**Florham Park New Jersey 07932(US)**

(72) Inventor: **Napoli, Joseph Dominic**
**11 Grandview Road**
**Windham New Hampshire 03087(US)**

(72) Inventor: **Tsien, Hsue Chu**
**11 Oak Hill Road**
**Chatham New Jersey 07928(US)**

(74) Representative: **Mitchell, Alan et al,**
**ESSO Engineering (Europe) Ltd. Patents & Licences Apex**
**Tower High Street**
**New Malden Surrey KT3 4DJ(GB)**

(54) **Attaching bus-bar to solar cell.**

(57) In order to quickly and easily fabricate solar cells with attached bus-bars, four bands of metal (11) each containing three adhesive strips (14, 15, 16) are fed to a strip-slicing machine (30). A solar cell (20) is fed to the machine (30) adjacent the four bands (11). A bus-bar strip is cut from each band (11) and simultaneously therewith, attached to the solar cell (20). A final solder dipping permanently attaches and electrically connects each bus-bar to the solar cell.

FIG. 2

"ATTACHING BUS-BAR TO SOLAR CELL"

The invention pertains to attaching one or more bus-bars to a solar cell, and more particularly though not exclusively to a manufacturing process for solar cells which can be achieved on a mass-production basis.

Heretofore, the attachment of bus-bars to solar cells has been accomplished on a manual basis, i.e. each solar cell was individually fabricated by hand.

It was realised that it would be most advantageous to automate the process of cutting the bus-bar strip and attaching them to the solar cells.

The mechanical handling of a long, thin bus-bar is very difficult, particularly where the metal strip is provided with adhesive in order to attach the strip to the solar cell.

According to the present invention there is provided a manufacturing method of attaching a bus-bar to a solar cell, comprising the steps of :

(a)     feeding at least one band of metal to a strip-slicing machine, said band of metal having attached thereto at least one adhesive strip;

(b)      feeding a solar cell into said strip-slicing machine adjacent said band of metal; and

(c)      cutting at least one bus-bar strip of metal with attached adhesive from said band and simultaneously therewith applying said strip against said adjacent solar cell to bond said bus-bar strip adhesively to said solar cell to form a solar cell with an attached bus-bar.

The attached bus-bar(s) is/are then permanently attached and electrically connected by subjecting the adhesively attached bus-bar(s) and solar cell to a solder dip.

In one arrangement, the adhesive strips attached to the metal band in the above-mentioned method have two adhesive surfaces. One of the surfaces is attached to the band, and the opposite adhesive surface has a protective backing which is removed prior to step (c).

The present invention can be put into effect with the result that the bus-bar strip is cut from a large metal band and then in the same motion, the strip is delivered and attached to the solar cell.

The simultaneous cutting and attaching of the bus-bar to the solar cell is considered a unique method step, since the proper orientation of the adhesive surface of the bar has to be carefully maintained to ensure that the bus-bar becomes affixed to the solar cell.  Furthermore the simultaneous step allows for a reduction in handling and processing time, and further streamlines solar cell manufacture.

This invention will be better understood with reference to the following detailed description, given by way of example and  considered in conjunction with the accompanying drawings, in which :-

Figure 1 is a schematic side view of a metal band with adhesive attached thereto, wherein the adhesive is having its protective backing removed;

Figure 1a is a cut-away top view of the adhesive strips arranged on the band of Figure 1;

Figure 2 is a partial front schematic view of a strip-slicing machine, and the metal band with adhesive being fed under the cutting die of the machine;

Figure 3 is a partial front schematic view of the strip-slicing machine of Figure 2, showing the cutting die delivering the adhesive strip to a solar cell for attachment thereto;

Figures 4, 5, and 6 are enlarged sequential views of the cutting die and guide apparatus of the strip-slicing machine illustrated in Figures 2 and 3, Figure 4 depicts the die about to cut a strip from the metal band, Figure 5 depicts the strip being guided through a die slot to the solar cell, and Figure 6 shows the strip being brought into adhesive contact with the solar cell;

Figure 7 is a plan view of a solar cell having bus-bars adhesively attached thereto; and

Figure 7a is a side view of the solar cell and attached bus-bars of Figure 7.

The description which follows relates to a method of fabricating solar cells with attached bus-bars. In more precise terms, it discloses a method whereby the bus-bars can be cut from band stock, and then simultaneously in the same cutting motion be adhesively affixed to the solar cell.

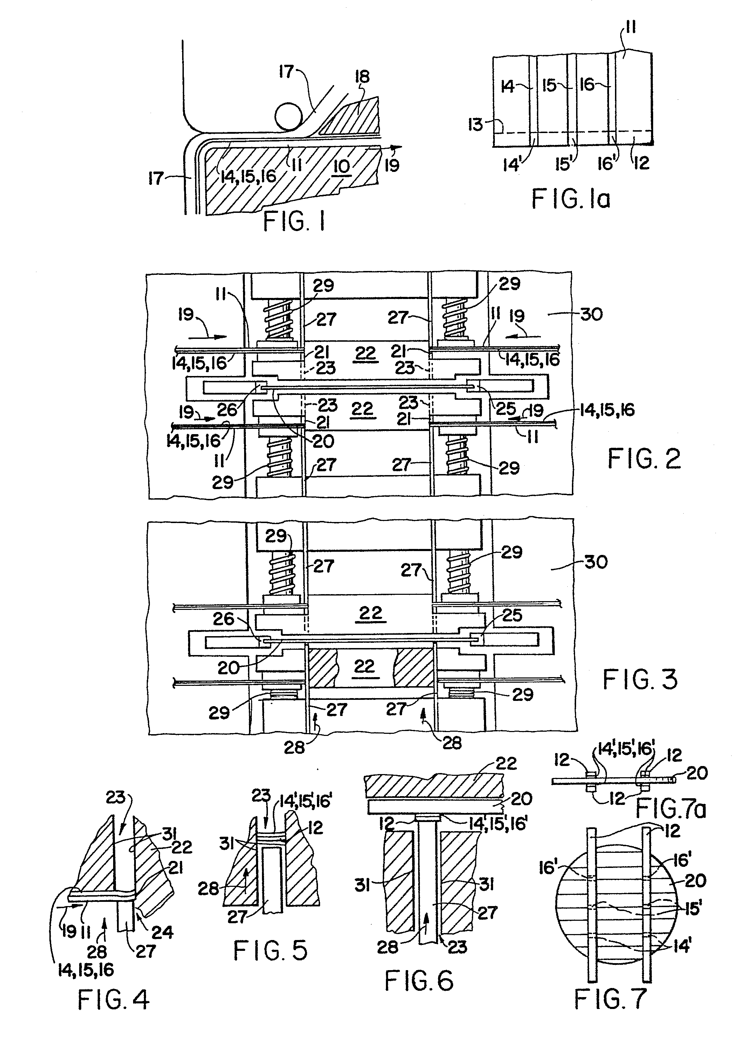

Now referring to Figure 1, a curved platform 10 is shown supporting a metal band 11. The metal band 11 also shown in Figure 1a, will eventually be cut into bus-bar strips 12, as delineated by the phantom line 13. The band 11 has disposed across its surface three strips of adhesive 14, 15, and 16, respectively. The adhesive strips 14, 15, and 16 are each adhesively sticky on both top and bottom sides thereof, so that they adhere to the band 11, and are also capable of subsequently being adhered to the solar cell 20 of Figure 7.

The adhesive strips 14, 15, and 16 each have a protective backing strip 17, which is peeled away by a knife blade 18, prior to the band 11 being fed to the strip-slicing machine 30, shown in Figures 2 and 3.

Four bands 11 as typically shown in Figures 1 and 1a, are fed to the strip slicing machine 30 of Figure 2 as illustrated by arrows 19.

Each metal band 11 with its associated adhesive strips 14, 15, and 16, respectively, is fed against a limiting abutment or stop 21, which is part of die blocks 22. The bands 11 are pressure fed against these stops 21, in order to provide a slight buckling in the band 11 above the die slots 23. This can be more clearly visualized with respect to Figure 4, which is an enlarged view of the band 11 being fed (arrow 19) against stop surface 21 of die block 22. As illustrated, the band and adhesive strips 14, 15, and 16 attached thereto, are caused to buckle above die slot 23, as shown by arrow 24. This buckling is intentional as will be explained hereinafter.

In addition to feeding the metal bands 11 to the strip-slicing machine 30, a solar cell 20 is likewise fed into the machine. Solar cell 20, is held in a desired orientation by clips 25 and 26. The solar cell is fed into the machine in a perpendicular direction to the feed (arrows 19) of the bands, i.e., into the face of the machine. The solar cell 20 is disposed between two upper bands 11 and two lower bands 11.

As aforementioned, a strip 12 is cut from each band 11 by the strip-slicing machine 30. This is accomplished by activating a strip cutter blade 27 for each band 11, as shown in Figure 3. First the two lower cutter blades 27 are activated, and the bands 11 are cut by the upward movement (arrows 28). The solar cell 20 is braced by upper die 22. A strip 12 is cut from each band and simultaneously pushed against the solar cell 20 by the upward movement of blade 27.

Three adhesive tabs 14', 15', and 16' are formed when the strip 12 is cut from band 11 (See Figure 1a).

When the strip 12 contacts the solar cell 20, the tabs 14', 15', and 16' bond the bus-bar strip 12 to the solar cell 20 as shown in Figures 7 and 7a.

After the two lower blades 27 are activated, the upper blades 27 cut two upper strips and affix them to the solar cell 20, producing a solar cell composite as shown in Figures 7 an 7a.

The cutting and bonding sequence can be seen in more detail in Figures 4, 5, and 6.

Referring to Figure 4, the band 11 is fed against abutment 21 and caused to buckle as shown by arrow 24. The band is held in a buckled condition by springs 29. When blade 27 cuts strip 12 as shown by arrow 28 in Figures 4 and 5, the buckling causes strip 12 to have a spring tension against the walls 31 of slot 23. This prevents the strip 12 from disorienting as it is pushed into final contact with solar cell 20, as shown in Figure 6.

The resulting solar cell with attached bus-bars of Figures 7 and 7a features four bus-bars 12, i.e., two upper and two lower strips.

The adhesive tabs 14', 15', and 16' hold each of the four strips to the solar cell 20.

After the solar cell and bus-bar combination is complete, the resulting assembly is withdrawn from the strip-slicing machine 30, and removed from holding clips 25 and 26.

In order to permanently adhere the bus-bars 12 to the solar cell 20, the resulting assembly is solder dipped, which also completes the electrical connection of the bars to the solar cell.

Soldering dipping does away with the previously used method of spot soldering which very often caused "hot spot" damage to the solar cell.

Other particulars of the resulting assembly may be obtained by reference to our published U.K. patent application 2,107,928-A.

CLAIMS :

1. A manufacturing method of attaching a bus-bar to a solar cell, comprising the steps of :

(a) feeding at least one band of metal (11) to a strip-slicing machine (30), said band of metal having attached thereto at least one adhesive strip (14);    .

(b) feeding a solar cell (20) into said strip-slicing machine (30) adjacent said band of metal (11); and

(c) cutting at least one bus-bar strip (12) of metal with attached adhesive from said band (11) and simultaneously therewith applying said strip (12) against said adjacent solar cell (20) to bond said bus-bar strip (12) adhesively to said solar cell (20) to form a solar cell with an attached bus-bar.

2. A manufacturing method according to claim 1, further comprising the step of :

(d) solder dipping said solar cell (20) with said attached bus-bar (12), to permanently attach and electrically connect said bus-bar to said solar cell.

3. A manufacturing method according to claim 1 or 2, wherein four bands of metal (11) are fed to said strip-slicing machine (30), and further wherein four bus-bar strips (13) are cut and attached to said solar cell.

4. A manufacturing method according to any preceding claim, wherein the or said adhesive strip (14) in step (a) has two adhesive surfaces, a first surface adhesively attached to said band of metal (11), and a second surface opposite said first surface and having a protecting backing (17) thereon, said manufacturing method further comprising the step of :

(e) prior to step (c), removing said protective backing from said second surface of the said adhesive strip (14).

5. A manufacturing method according to any preceding claim, wherein there are three adhesive strips (14, 15, 16) attached to said metal band (11).

6. A manufacturing method according to any preceding claim, wherein the or each band of metal (11) is fed, in step (a), into the strip-slicing machine (30) against an abutment (21) and thereby caused to buckle, and the band is held in its buckled condition until step (c) is performed.

0124975

FIG. 1

FIG. 1a

FIG. 2

FIG. 3

FIG. 4

FIG. 5

FIG. 6

FIG. 7

FIG. 7a

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | DE-A-2 757 301 (LEYBOLD-HERAEUS) * Claim 8; page 14, line 26 - page 15, line 2; page 16, line 36 - page 17, line 11; figure 1 * | 1,4 | H 01 L 31/18<br>H 01 L 21/60<br>H 01 L 21/68 |
| | --- | | |
| A | US-A-4 364 508 (G. LAZZERY et al.) * Claims 1, 3 * | | |
| | --- | | |
| A | DE-A-2 919 041 (MESSERSCHMITT-BÖLKOW-BLOHM) * Claim 2 * | | |
| | ----- | | |

TECHNICAL FIELDS SEARCHED (Int. Cl. ³)

H 01 L 21/60
H 01 L 21/68
H 01 L 31/02
H 01 L 31/18
H 05 K 13/06

The present search report has been drawn up for all claims

| Place of search BERLIN | Date of completion of the search 20-06-1984 | Examiner ROTHER A H J |
|---|---|---|